Europäisches Patentamt

European Patent Office

Office européen des brevets

(11) Publication number : **0 375 107 B1**

(12) **EUROPEAN PATENT SPECIFICATION**

(45) Date of publication of patent specification :
04.10.95 Bulletin 95/40

(51) Int. Cl.⁶ : **H01L 43/08**

(21) Application number : **89307120.9**

(22) Date of filing : **13.07.89**

(54) Improved magnetoresistors.

(30) Priority : **23.12.88 US 289646**

(43) Date of publication of application :
**27.06.90 Bulletin 90/26**

(45) Publication of the grant of the patent :
**04.10.95 Bulletin 95/40**

(84) Designated Contracting States :
**DE FR GB IT NL SE**

(56) References cited :
**US-A- 3 898 359**
**US-A- 4 568 905**
**ELECTRONICS & COMMUNICATIONS IN**
**JAPAN, PART II - ELECTRONICS, vol. 71,**
**March 1988, New York, US, pp. 110-115 ;**
**Takashi Taguchi et al.: "AlGaAs/GaAS Hetero-**
**junction Hall Device"**
**HALBLEITER-ELEKTRONIK (Eds. W.Heywang**
**& R.Müller), vol. 2, Springer-Verlag, Berlin**
**1987, pp. 159 and 167-169**

(73) Proprietor : **GENERAL MOTORS**
**CORPORATION**
**General Motors Building**
**3044 West Grand Boulevard**
**Detroit Michigan 48202 (US)**

(72) Inventor : **Partin, Dale Lee**
**37728 Alper Drive**
**Sterling Heights MI 48077 (US)**
Inventor : **Heremans, Joseph Pierre**
**2640 Lanergan**
**Troy MI 48084 (US)**
Inventor : **Morelli, Donald Thomas**
**860 Spring Drive**
**Northville MI 48167 (US)**

(74) Representative : **Denton, Michael John et al**
**Patent Section**
**1st Floor**
**Gideon House**
**28 Chapel Street**
**Luton Bedfordshire LU1 2SE (GB)**

## Description

### Field of the Invention

This invention relates to magnetic field sensors, for example as described by S.Kataoka in "Recent development of Magnetoresistive Devices and Applications", Circulars of Electrotechnical Laboratory No.182, Agency of Industrial Science and Technology, Tokyo (December 1974), and more particularly to improved thin film magnetoresistors and to methods of making such a magnetoresistor.

### Background of the Invention

In the past, magnetoresistors were believed to be best formed from high carrier mobility semi-conductive material in order to get the highest magnetic sensitivity. Hence, the focus was on making magnetoresistors from bulk materials that were thinned down or on films having sufficient thickness to exhibit a high average mobility.

A sensor in accordance with the present invention is characterised by the features specified in claim 1.

The inventors have found a new way to approach making magnetoresistors. The inventors have found that if an accumulation layer is induced in the surface of an extremely thin film of semi-conductive material, the properties of the accumulation layer relevant to magnetic sensitivity can dominate over those of the remainder of the film.

Such accumulation layers can make higher band gap semi-conductor materials useful in magnetosensors. Such materials can be used at higher operating temperatures than lower band gap semi-conductive material, such as indium antimonide. However, it may even enhance the sensitivity of indium antimonide enough to allow it to be used at higher temperatures.

### Summary of the Invention

From the foregoing, it is apparent that this invention involves a magnetoresistor formed in a film having an accumulation layer of current carriers, and in which the magnetic change in conductivity of the accumulation layer is not masked by conductivity of the balance of the film. The accumulation layer can be of the same conductivity type as that of the film or of opposite conductivity type. An opposite conductivity type accumulation layer is also referred to as an inversion layer but is considered to be within the scope of the phrase "accumulation layer" as used in this patent application.

This invention is especially directed to use of an accumulation layer in magnetoresistors made of higher band gap semi-conductive materials. However, it is expected to be beneficial in magnetoresistors made of still other semi-conductive materials.

This invention also provides new magnetoresistor constructions and methods of making magnetoresistors.

### Description of the Drawings

Figure 1A is a schematic view of a magnetoresistor, showing its electrical current flow lines when no magnetic field is applied to it.

Figure 1B is a schematic view of a magnetoresistor, showing how the electrical current flow lines shown in Figure 1A are re-directed in the plane of a major surface of the magnetoresistor when a magnetic field is applied perpendicular to that surface.

Figure 2 is an isometric view showing a magnetoresistor having two integral sensing areas electrically in parallel.

Figure 3 is a three-dimensional or contour plot showing the change of electrical resistance in a single element larger band gap semi-conductor magnetoresistor with changes in temperature and magnetic field strength.

Figure 4 is a two-dimensional plot of the fractional magnetoresistance over a wider temperature range than shown in Figure 3.

Figure 5 is a two-dimensional plot showing change in resistance with no magnetic field applied over a wider temperature range than shown in Figure 3.

Figure 6 is an elevational view showing a semi-conductor film in a pattern for providing a series-connected plurality of sensing areas integrated in a single magnetoresistor.

Figure 7A is an elevational view showing a metallization pattern for superposition on the Figure 6 pattern.

Figure 7B is an elevational view showing the Figure 7A metallization pattern superimposed on the Figure 6 semi-conductor pattern to delineate the plurality of sensing areas.

Figure 8 is a three-dimensional or contour plot showing the change of electrical resistance of a multiple sensing area magnetoresistor such as shown in Figure 7B.

Figures 9 and 10 are two-dimensional electron energy to depth plots showing how electrons could be confined in an accumulation layer under special layers on a surface of the sensing area of the magnetoresistor.

## Description of the Preferred Embodiments

A typical magnetoresistor element consists of a slab of semiconductor, typically rectangular in shape, through which a current is passed. Such a magnetoresistor is described by S. Kataoka in "Recent development of Magnetoresistive Devices and Applications," Circulars of Electrotechnical Laboratory No. 182, Agency of Industrial Science and Technology, Tokyo (December 1974).

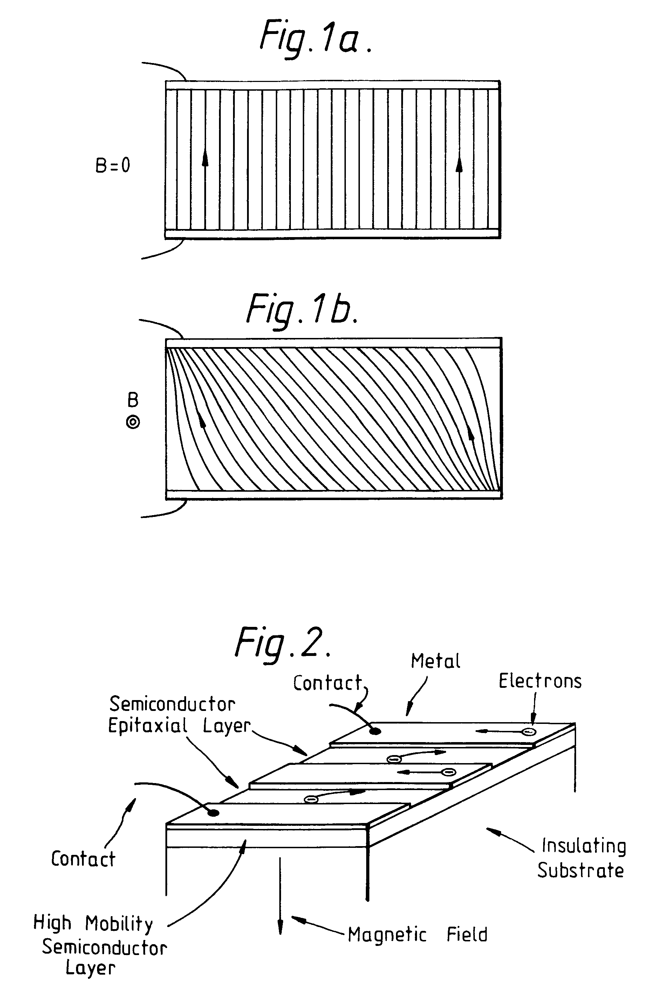

In the absence of a magnetic field, the current lines go from one injecting electrode to the other in parallel lines (see Figure 1A). This flow is between electrodes along the top and bottom edges of the rectangle in Figure 1A. The configuration (a rectangle in this example) is chosen so that an applied magnetic field, perpendicular to the slab, increases the current line trajectory (see Figure 1B). The magnetic field perpendicular to the plane of the rectangle thus lengthens the current flow lines. The longer length leads to higher electrical resistance, so long as the resulting lateral voltage difference is electrically shorted, as shown, by the top and bottom edge electrodes.

The best configuration for this effect to occur is one where the current injecting electrodes are along the longest side of the rectangle, and the ratio of this dimension ("width") to the shortest dimension ("length") is as large as possible. For the present invention, the length of the short edges of the rectangular sensing area is preferably about 30% to 50% of the length of the long edges of the rectangular sensing area. Such an optimal device configuration hence leads to a very low resistance. Kataoka teaches that the magnetic field sensitivity of such devices is best when the devices are made out of semi-conductors with as large a carrier mobility as possible. The resistivity of such devices is made less temperature-dependent when the semi-conductor material contains a large donor concentration, giving a large carrier density. These last two constraints imply that semi-conductors with high electrical conductivity are best suited for practical applications.

Combined with the geometrical restrictions described earlier, one can deduce that the final magnetoresistor element will have a low resistance. This has a practical drawback. Under a constant voltage, the power dissipated by the device is proportional to the inverse of the resistance. To limit ohmic heating (which would limit the operational temperature range of the sensor, if not destroy the sensor itself) whilst maintaining a large voltage output during sensor interrogation, it is desirable that a magnetoresistive element have a resistance around 1 k$\Omega$. The inventors consider this to typically be equivalent to a resistance of about 300$\Omega$-3k$\Omega$. A number of ways have been proposed to achieve such resistances. For example, as Kataoka has pointed out, one can put a number of elementary devices in series. Making a plurality of sensing areas as integral parts of a single element is shown in Figure 2. Whilst only two sensing areas (i.e., devices) are shown, one could make an element with tens or hundreds of integral sensing areas (i.e., devices).

If the metal-semi-conductor (magnetic-field independent) interfacial contact resistance of one such elementary device is an appreciable fraction of the semi-conductor resistance of this elementary device, it will lower the sensitivity to a magnetic field. Thus, metals must be deposited which have a very low metal-semi-conductor interfacial contact resistance to avoid this sensitivity degradation. In most cases it would be preferable that the interfacial contact resistance between the sensing area and its electrodes be 10-100 times less than the resistance of the sensing area between those electrodes. Another option which alleviates the problem of low magnetoresistor device resistance has been to use active layers that are as thin as possible. This has been done by thinning wafers of indium antimonide (InSb), which were sliced from bulk ingots, down to thicknesses as small as 10 micrometres. The wafer thinning process is a very difficult process, since any residual damage from the thinning process will lower the electron mobility. Reducing electron mobility will decrease the sensitivity to a magnetic field of devices made from this material.

Another approach has been to deposit films of InSb onto an insulating substrate. On the other hand, in this latter case, the electron mobility of the resulting films is reduced to a fraction of that of bulk InSb. This reduction occurs because of defects in the film. With typical mobilities of 20,000 cm$^2$V$^{-1}$sec$^{-1}$, these films produce devices with greatly reduced sensitivity to a magnetic field compared to devices made from bulk InSb. The usual device structure for the prior magnetoresistors made from a film is schematically shown in Figure 2.

The great majority of the prior work until now has focused on InSb. This can be understood from the data in the following Table I.

TABLE I

## Potential Magnetoresistor Materials at $300^{\circ}$K

| Semi-conductive Material | Maximum Electron Mobility ($cm^2V^{-1}sec^{-1}$) | Crystal Lattice Constant (A) | Energy Band Gap (eV) |
|---|---|---|---|
| InSb | 78,000 | 6.478 | 0.17 |
| $Bi_{1-x}Sb_x$ (x<0.2) | 32,000 | 6.429(Bi) | 0-0.02 |
| InAs | 32,000 | 6.058 | 0.35 |
| $In_{0.53}Ga_{0.47}As$ (on InP) | 14,000 | 5.869 | 0.75 |
| GaAs | 8,000 | 5.654 | 1.4 |
| GaSb | 5,000 | 6.095 | 0.68 |
| InP | 4,500 | 5.869 | 1.27 |

Since the magnetoresistance effect is proportional to the square of the electron mobility for small magnetic fields, InSb is highly preferable. However, the difficulty of growing compound semi-conductors in general, and the fact that there is no suitable, lattice-matched, insulating substrate upon which it may be grown led the inventors to try growing Bi films. Such work has been previously reported by Partin et al. in Physical Reviews B, 38, 3818-3824 (1988) and by Heremans et al. in Physical Reviews B, 38, 10280-10284 (1988). Although the inventors succeeded in growing the first epitaxial Bi thin films, with mobilities as high as 25,000 $cm^2V^{-1}$ $sec^{-1}$ at 300°K (and 27,000 $cm^2V^{-1}sec^{-1}$ for $Bi_{1-x}Sb_x$ at 300°K), magnetoresistors made from these films had very low sensitivities. Modelling studies which the inventors have just completed indicate that this is to their knowledge an unrecognized effect of the fact that the energy band structure of Bi has several degenerate conduction band minima. Other high-mobility materials shown in Table I have a single, non-degenerate conduction band minimum. The inventors then began growing InSb thin films (on semi-insulating GaAs substrates) using the metal organic chemical vapor deposition (MOCVD) growth technique. After many months of effort, the inventors could only produce films with electron mobilities of 5,000 $cm^2V^{-1}sec^{-1}$.

The inventors then tried growing Indium Arsenide (InAs) on semi-insulating GaAs, and also on semi-insulating InP substrates. By "semi-insulating" is meant substrates of such high resistivity that they can be considered as substantially insulating. These latter substrates were made semi-insulating by doping them with Fe. They were tried in addition to GaAs because there is less lattice mismatch with InAs (see Table I). After some time, the inventors were able to produce InAs films with a room temperature mobility of 13,000 $cm^2V^{-1}sec^{-1}$ on InP substrates, and of lower mobility on GaAs substrates. The better InAs films were formed by the following process.

An MOCVD reactor manufactured by Emcore Corporation, U.S.A. was used. InP substrates were heated to the growth temperature in an atmosphere of 5333 Pa (40 torr) of high purity (palladium-diffused) hydrogen to which a moderate quantity of arsine was added (80 SCCM, or standard cubic centimetres per minute). This produced about 0.02 mole fraction of arsine. The arsine was used to retard thermal decomposition of the InP surface caused by loss of the more volatile phosphorus. The way in which arsine reduces the surface roughening during this process is not well understood. Phosphine would have been preferred, but was not available at the time in the reactor. After reaching a temperature of 600°C, the arsine flow was reduced to 7 SCCM, and ethyl-dimethyl indium (EDMIn) was introduced into the growth chamber by bubbling high purity hydrogen (100 SCCM) through EDMIn which was held at 40°C. Higher or lower arsine flows during growth gave lower mobilities and worse surface morphologies. After 2.5 hours of InAs growth time, the EDMIn flow to the growth chamber was stopped and the samples were cooled to room temperature in an arsine-rich atmosphere (as during heat-up).

The thickness of the resulting InAs film was 2.3 micrometres. From conventional Hall effect measurements at 300°K, the electron density was $1.4 \times 10^{16}$ cm$^{-3}$ and the electron mobility was 13,000 cm$^2$V$^{-1}$sec$^{-1}$. These are effectively averages since the electron density and mobility may vary within a film. The film was not intentionally doped. Even though this is a very disappointing mobility, a crude magnetoresistor was made, since this required very little effort. A rectangular sample was cleaved from the growth and In metal was hand-soldered along two opposing edges of the sample, and leads were connected to the Inmetal. The length, which is the vertical dimension in Figures 1A and 1B, was 2 mm and the width, which was the horizontal dimension in Figures 1A and 1B, was 5 mm.

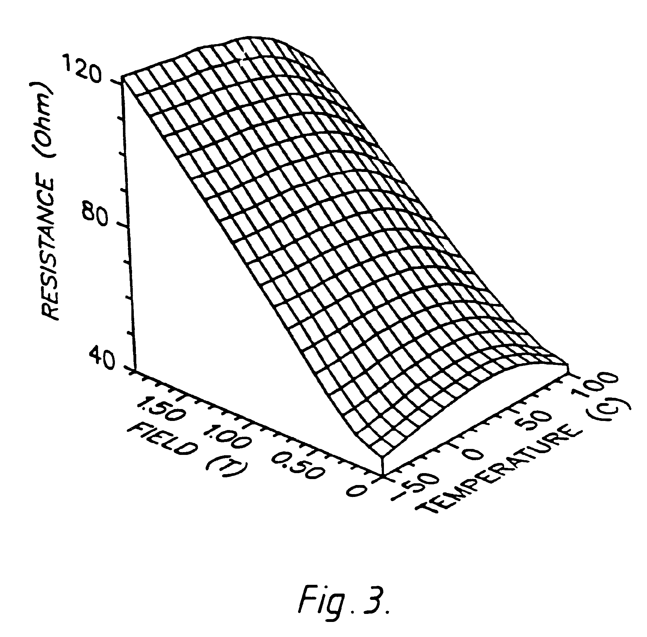

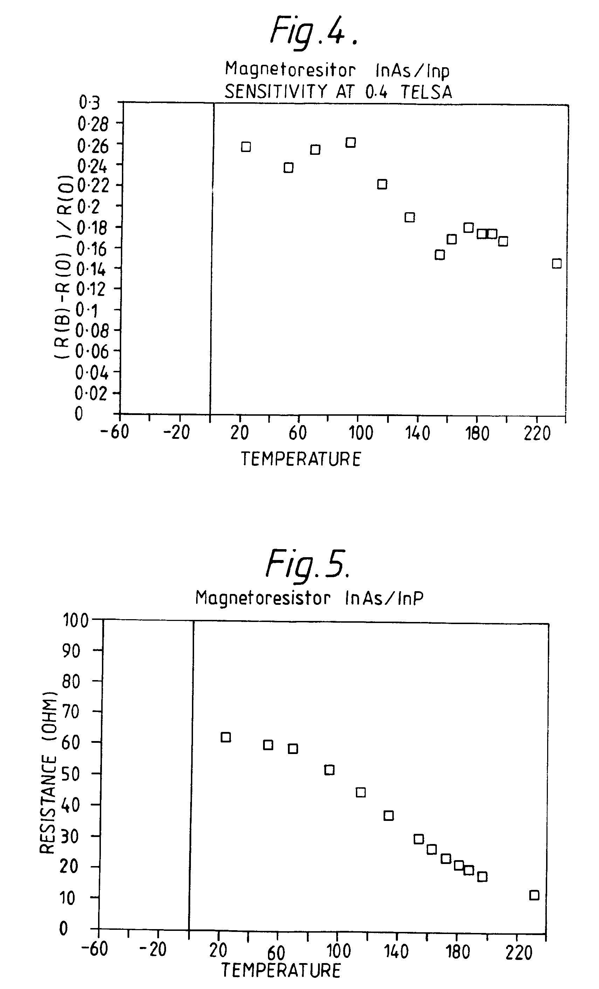

As expected, the resistance of the device was low (about 50 $\Omega$) since the inventors did not have many elements in series. However, the magnetoresistance effect was large. It is shown in Figure 3. Furthermore, the device resistance and magnetoresistance were surprisingly stable with temperature in the range shown in Figure 3, which is -50°C to +100°C. A second, similar device was tested less thoroughly at temperatures as high as +230°C. The results of this latter testing are shown in Figures 4 and 5. In Figure 4, the applied magnetic field was 0.4 Tesla. The fractional magnetoresistance is plotted as a function of temperature between B = 0.4 Tesla and B = 0. Despite the fact that the indium metal used for contacts has a melting point of 156°C, the magnetoresistor still functioned very surprisingly well at 230°C, with the fractional increase in resistance for a given magnetic field (0.4 Tesla) reduced by less than one half compared to the response near room temperature (as shown in Figure 4).

The device resistance in zero magnetic field, R(0), decreased over the same temperature range by a factor of 5 (as shown in Figure 5). The inventors also found this to be surprisingly good, even taking into account the relatively large energy gap of InAs.

The inventors own detailed analysis of transport data from these films suggests that there are current carriers with two different mobilities present. In retrospect, it looks like the results are related to an accumulation layer of electrons at the surface of the sensing layer. The inventors have now found that Wieder has reported in Appl. Phys. Letters, 25, 206 (1974) that such an accumulation layer exists just inside the InAs near the air-/InAs interface. It appears to the inventors that there are some errors in the Wieder report. However, the inventors think that the basic conclusion that an electron accumulation layer exists is correct. These electrons are spatially separated from the positive charge at the air/InAs interface. Thus, they are scattered relatively little by this charge, resulting in a higher mobility than would normally be the case. They also exist in a very high density in such an accumulation layer, so that, as the temperature increases, the density of thermally-generated carriers is a relatively small fraction of the density in the accumulation layer. This helps stabilize the resistance (at zero magnetic field) with temperature. Thus, it appears that the relatively low measured electron mobility of 13,000 cm$^2$V$^{-1}$sec$^{-1}$ is an average for electrons in the accumulation layer and for those in the remainder of the thickness of the film.

Thus, normally one would want to grow a relatively thick layer of InAs to make a good magnetoresistor, since crystal quality (and mobility) generally improve with thickness when growing on a lattice-mismatched substrate. However, the thicker the layer becomes, the greater its conductivity becomes and the less apparent the benefits or presence of a surface accumulation layer would be. Thus, the inventors' current understanding of their devices suggests that relatively thinner layers are preferable, even if the average film mobility decreases somewhat, since this will make the conductivity of the surface accumulation layer a greater fraction of the total film conductivity. In a preferred method of making such a sensor using an indium phosphate substrate, a metal organic chemical vapor technique is used to deposit a nominally undoped monocrystalline film of indium arsenide onto said substrate to a thickness of less than 5 micrometres. Preferably this preferred method also includes exposing said deposited film to air. The exact relationships between film thickness, crystal quality and properties of the surface accumulation layer are currently under study.

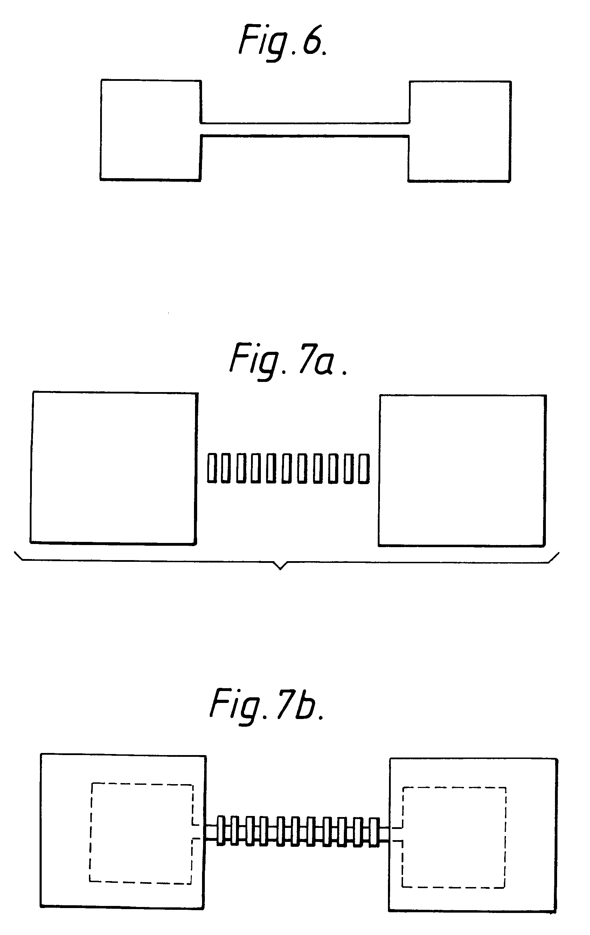

The inventors have since made multi-element magnetoresistors from this material using Au (or Sn) metallization. Such multi-element magnetoresistors usually contain over ten discrete sensing areas. First, conventional photolithography techniques were used to etch away unwanted areas of an Indium Arsenide (InAs) film from the surface of the Indium Phosphide (InP) substrate to delineate the pattern shown in Figure 6. A dilute solution (0.5%) of bromine in methanol was used to etch the InAs. Then, a blanket layer of Au metallization 100 nanometres (1000 Angstroms) thick was deposited using conventional vacuum evaporation techniques over the entire surface of the sample, after removing the photoresist. Conventional photolithography was then used to etch away unwanted areas of the Au film to delineate the gold pattern shown in Figure 7A. A dilute aqueous solution of KCN was used for this step. (The inventors think dissolved oxygen is helpful, which can diffuse into the solution from ambient air or be supplied in the form of a very small addition of hydrogen peroxide.) The resultant composite of the two patterns, with the gold pattern overlying the InAs film pattern, is shown in Figure 7B.

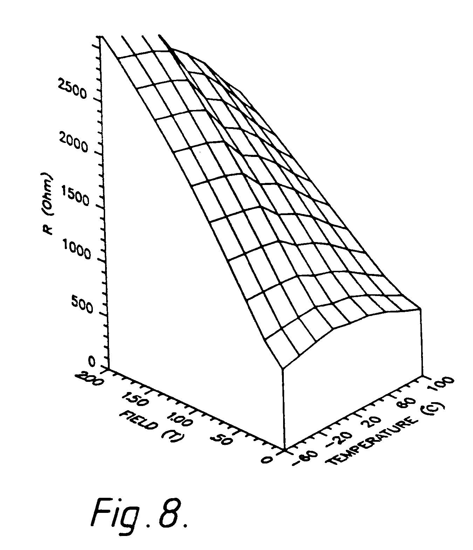

Leads were then attached by silver epoxy resin to the large Au end bonding pads. Leads could also be attached by normal and accepted filamentary wire-bonding techniques. If so, and especially if a modern wire-bonding apparatus were used, the bonding pads could easily be made much smaller. Also, many devices such as shown in Figures 6,7A and 7B could be made simultaneously using conventional integrated circuit technology. The resulting devices typically have a resistance near 1 K$\Omega$ (typically + or - 20%) at room temperature in zero magnetic field. Surprisingly, the magnetoresistance effect on the multi-sensing area device was much larger than the effect on a single sensing area device. For comparison, of these effects at a given magnetic field, see Figures 8 and 3. In the multi-element device (i.e., plural sensing area element), the sensing areas had a length to width ratio of 2/5. The inventors do not understand why the multi-element device works better since the length to width ratio of each element is 2/5, the same as for the single element device characterized in Figure 3, which was fabricated using part of same InAs grown layer. Another multi-element magnetoresistor was made similarly to the one just described, but with a length to width ratio of 4/5. It had nearly as large a magnetoresistance as the one made according to the patterns in Figures 6, 7A and 7B. Again, the inventors do not yet understand this, but the resulting devices work very well. Even a device with a length to width ratio of 6/5 works well.

The relative stability of these magnetoresistors with temperature also now appears to be increasingly important, since some automotive applications require operation from -50°C to as high as +170°C to +200°C, and there are known applications requiring even higher temperatures (to 300°C). There is reason to believe that the present invention will provide magnetoresistors operating at temperatures as high as 300°C, and even higher.

A potential problem with InAs magnetoresistors made in accordance with this invention is the potential importance of the air/InAs interface, which might cause the device characteristics to be sensitive to changes in the composition of ambient air, or cause the characteristics to slowly change with time or thermal history because of continued oxidation of the surface. A preferred sensor according to this invention is one in which there is a protective but gas-permeable coating over each sensing area of the sensor. Preferably such a coating is permeable to ambient air. The inventors have tried coating the surfaces of two devices with a particular epoxy resin made by Emerson and Cuming, a division of Grace Co. U.S.A. The epoxy resin used was "Stycast", number 1267. Parts A and B were mixed, applied to the devices, and cured at 70°C for two hours. The inventors did not observe any significant changes in the device characteristics at room temperature as a result of this encapsulation process. The inventors have not yet systematically tested these devices at other temperatures, but they are encouraged by this preliminary result. The inventors think other forms of encapsulants need to be explored, such as other epoxy resins and thin film dielectrics, such as $SiO_2$ or $Si_3N_4$.

In order to still have a very low metal-semi-conductor contact resistance between the InAs and the contact and shorting bar metallization, it may be necessary to modify the processing sequence previously described in connection with Figures 6, 7A and 7B. For example, with an inverse of the mask contemplated in the previous discussion, the photoresist on the surface could then be used as a mask for wet-etching (e.g., by wet chemicals or reactive ions, or ion beams) of the dielectric or high energy gap semi-conductor layer to expose the InAs. Au or other metals could then be deposited by vacuum evaporation (or by other conventional processes, such as sputtering, or electroplating) and then the photoresist could be removed, resulting in lift-off of the undesired regions of metal. Alternatively, after etching through to the InAs, the photoresist could be removed, Au or other metal could be deposited uniformly across the surface, and then, after deposition of photoresist, the mask pattern in Figure 7A could be aligned with the pattern etched into the dielectric and the Au could be patterned as before.

As an additional alternative, if a sufficiently thin layer (e.g., 20 nanometres (200 Angstroms)) of high energy gap semi-conductor is present, the original processing sequence described could be modified by deposition of a low-melting-temperature eutectic alloy, such as Au-Ge, Au-Ge-Ni,or Ag-Sn, in place of Au. After patterning similarly to the way the Au was patterned (or using the inverse of the mask in Figure 7 and lift-off), the sample is heated to a moderate temperature, typically to somewhere in the range of 360°C to 500°C for Au-Ge-based alloys, thus allowing the liquid metal to locally dissolve the thin layer of high energy gap semi-conductor, effectively contacting the InAs.

In the most recent work, the inventors have changed the InAs growth procedures somewhat. The procedures are the same as before, but the InP wafer is heated to 460°C in a larger arsine mole fraction (0.1). After 0.5 minutes at 460°C, during which the native oxide on InP is believed to desorb, the temperature is lowered to 400°C and 20 nanometres (200 Angstroms) of InAs in thickness is grown. The temperature is then raised to the growth temperature of 625°C (with the arsine mole fraction still 0.1), and then EDMIn is introduced while the arsine flow is abruptly reduced to 5 SCCM (about 0.001 mole fraction). The EDMIn is kept at 50°C, and the high purity hydrogen is kept bubbling through it at a rate of 75 SCCM. Again, the arsine flow of 5 SCCM seems near-optimal for these growth conditions. The resulting films have somewhat enhanced sensitivity to a magnetic field relative to those grown earlier.

Whilst all of the recent work has concentrated on magnetoresistors fabricated from InAs films on semi-insulating (i.e., substantially electrically insulating) InP substrates, the inventors think that a more mature growth capability will permit films of InAs with nearly comparable quality to be grown on semi-insulating GaAs substrates as well. In either case, other growth techniques such as molecular beam epitaxy, liquid phase epitaxy or chloride-transport vapor phase epitaxy may also prove useful.

The above-mentioned Indium Arsenide (InAs) thin film devices, fabrication processes, and operating characteristics are described and claimed in a separate European patent application number 0 375 108A based on USSN 289,634, that is being simultaneously filed with this patent application.

On the other hand, the inventors think that the presence of what may be a naturally-occurring accumulation layer in the above-mentioned thin film InAs magnetoresistors is what makes them work so well, and which enables production of a practical device. The inventors believe that this fundamental concept is new to magnetoresistors, and that this concept can be expanded in a multiplicity of ways, not only to Indium Arsenide but to other semi-conductive materials as well. In this patent application is further described and claimed a variety of techniques by which an accumulation layer can be induced in the semi-conductor layer, by other than a natural occurrence or inherent occurrence as a result of the fabrication process.

The following discussion describes some of the other ways of inducing or enhancing an electron accumulation or inversion layer in InAs thin films and in other semi-conductive materials in thin film form, to attain effective high mobilities. There are three basic advantages to the use of strong electron accumulation layers in magnetoresistor active regions. It is repeated here that the term "electron accumulation layer", as used in this patent application is also intended to include electron inversion layers.

First, electron accumulation layers or strong electron inversion layers can contain a density of electrons significantly larger than the intrinsic density at any given temperature. This must improve the temperature stability, since the thermally-excited carriers are a small fraction of the accumulated or strongly inverted ones.

Second, accumulation layers enhance the mobility of the carriers in the semi-conductor. This effect has been experimentally observed in thin indium arsenide (InAs) films, especially at higher temperatures. They will enhance the sensitivity of the magnetoresistor. One possible cause of this effect may be that in such accumulated or strongly inverted layers large electron densities can be achieved without the presence of a large density of ionized impurities in the same spatial region, which would limit the carrier mobility. This effect is similar to the "modulation doping" of layers described by G. Burns in Solid State Physics, pp. 726-747, Academic Press (1985). Such an effect is used in the fabrication of High-Electron-Mobility-Transistors (HEMTs).

Third, accumulation or strong inversion layers are inherently close to the surface or interface of a semi-conductor. This makes it relatively easy to induce, enhance, or control these accumulation or strong inversion layers through the use of thin film structures deposited on top of the semi-conductor, possibly in combination with voltage biases.

Accumulation layers have been used in silicon MOSFET Hall plates, and are described by H.P. Baltes et al. in Proc. IEEE, 74, pp. 1107-1132, especially pp. 1116-7, (1986). In the MOSFET Hall effect devices, a biased gate electrode in a Metal-Oxide-Semi-conductor was used to generate a suitably thin electron layer close to the Semi-conductor-Oxide interface. Four electrodes were then used to contact that layer: a source and a drain through which current is passed, and two intermediate electrodes across which the Hall voltage is generated. Further, Baltes et al. ibid. also describe a split-drain MOSFET using an accumulation-layer based sensor with only four electrodes (one source, two drains, and one gate). One of the virtues of a magnetoresistor over a Hall effect device is that the magnetoresistor has only two electrodes. In order to preserve this in the improved magnetoresistor concept of the present invention, the inventors propose to use, in conjunction with a magnetoresistor layout such as described in Figure 2, a number of new ways to generate accumulation or inversion layers without using externally-biased gate electrodes.

In a first embodiment, use is made of the fact that the natural interface between InAs and air is known to generate an electron accumulation layer in InAs. A similar effect may exist in InSb, and the technique may therefore be applicable to thin film magnetoresistors made with this semi-conductor material. The inventors would not, however, expect such devices to work as well as InAs at very high temperatures. The very small energy gap of InSb (see Table I) would cause thermal generation of carriers that would cause increased conductivity in the InSb film adjacent to the accumulation layer, making the conductivity of the accumulation layer a relatively small fraction of the total device conductivity. Thus, the benefits of the accumulation layer would be lost at a lower temperature in InSb than in the higher energy band gap InAs. The inventors experimentally grew a 2.3 micrometre thick epitaxial layer of InAs on an insulating InP substrate using Metal Organic Chemical Vapor Deposition (MOCVD). Hall and magnetoresistance measurements on the layer in the temperature range of 350°K to 0.5°K, and in magnetic fields up to 7 Tesla reveal the presence of at least two "types" of carriers, in roughly equal concentrations, but with very different mobilities (by a factor of 2 to 3). In retrospective view of the afore-mentioned Wieder publication, it is reasonable to assume that one of them is the accumulation layer located near the air interface. The inventors built two 2 mm long, 5 mm wide magnetoresistors out of this film which developed a very usable magnetic field sensitivity, whilst maintaining good temperature stability (see Figs.3, 4, and 5). The inventors believe it is possible to preserve this sensitivity after covering the InAs surface with a suitable encapsulating coating (e.g., an epoxy resin or other dielectric material).

In a second embodiment, a capping layer of a large-gap semi-conductor such as GaAs, InP, AlSb, or $In_{1-y}Al_yAs$ can be grown on top of the narrow-gap active layer semi-conductor (typically InAs or $In_{1-x}Ga_xAs$ with $0<x<0.5$, although a similar structure using InSb can be conceived). In this capping layer, the inventors put donor-type impurities, such as Si, Te, Se, or S. These will release an electron, which will end up in the layer where it has minimum energy, i.e., the narrow-gap semiconductor. This leaves a layer of positively ionized donor-impurities in the large-gap capping layer; but they are spatially removed from the electrons in the active layer, and hence do not significantly scatter them.

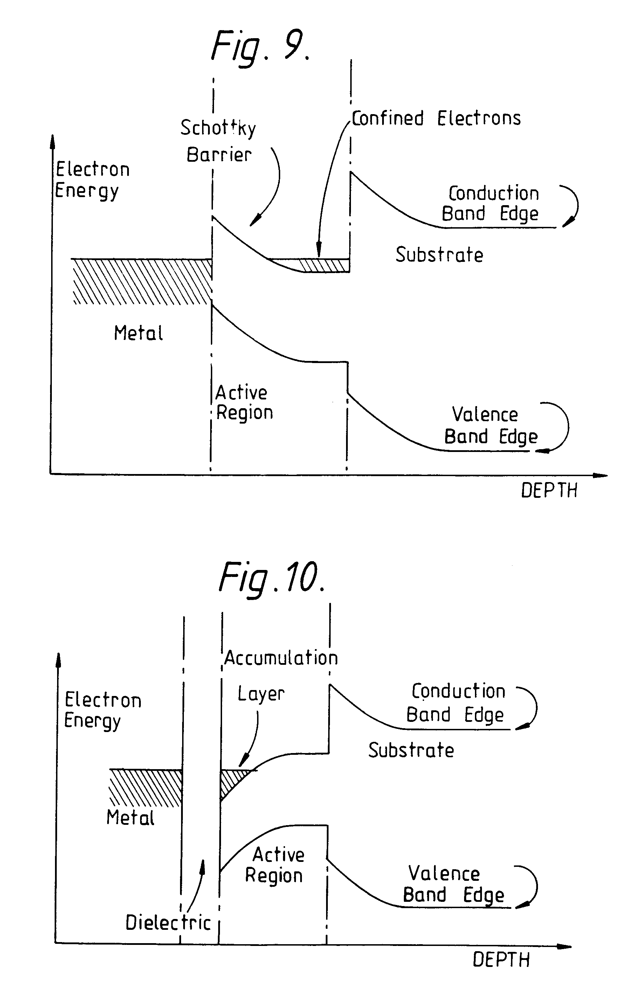

In a third embodiment, the inventors propose to deposit a layer of metal on top of the device active region with the purpose of creating a Schottky barrier. A plot of the electron energy levels adjacent the metal-semi-conductor interface in this third embodiment is shown in Figure 9. In referring to Figure 9, it can be seen that there will be a depletion of the top region of the active narrow-gap semi-conductor. If the active layer is thin enough (100-200 nanometres (1000-2000 Angstroms)), this will confine electrons in the active layer towards the substrate, resulting in electrical properties similar to those of an accumulation layer. Metals that generally form Schottky barriers to III-V compounds, such as Au or Al may be useful, although the inventors have not adequately studied this structure experimentally yet.

In a fourth embodiment, the inventors propose to deposit on the active layer of a narrow-gap semi-conductor a layer of large-gap semi-conductor, or of a dielectric such as $SiO_2$ or $Si_3N_4$, and on top of that a gate electrode. An electron energy plot going through the layers at the relevant interfaces is shown in Figure 10. The metal of the gate electrode in Figure 10 can be chosen such that it induces an accumulation region near the semi-conductor-dielectric interface, by effect of the difference between the electron affinity in the semi-conductor, and the work function in the metal. Conversely, a different metal with larger work function can be used to deplete the semi-conductor-dielectric interface and electrostatically confine the electrons near the substrate, much as in the third embodiment mentioned above.

In a fifth embodiment, a lightly p-type film is grown (typically doped with Zn, Cd, Mg, Be, or C). In the case of InAs, the surface would, the inventors believe, still have a strongly degenerate electron layer, but it would be an inversion layer. Such an inversion layer would have a large electron density near the surface, and then a relatively thick (typically 0.1 mm to 1 mm or more, depending on dopant density) region of very low carrier density, similar to the space charge region of an n+/p junction. This might be advantageously used to reduce the conductivity of the film adjacent to the electron strong-inversion layer. At very high device operating temperatures, the intrinsic carrier density of narrow energy gap semi-conductors like InAs would tend to defeat this strategy somewhat, and other, higher energy gap semi-conductors such as $In_{1-x}Ga_xAs$ might be preferred (see Table I). $In_{0.53}Ga_{0.47}As$ is a special case, since it can be lattice-matched to semi-insulating InP substrates. This makes it easier to grow such films with high crystalline quality.

The acceptor dopants mentioned above (i,.e., Zn, Cd, Mg, Be, and C) have small activation energies in the III-V compounds of interest (see Table 1). However, there are other acceptor dopants with relatively large activation energies, such Fe, in $In_{0.53}Ga_{0.47}As$. This means that relatively large thermal energy is required to make the iron ionize and contribute a hole to conduction. However, the iron will compensate for a concentration of donor impurities frequently present in the material so that they do not contribute electrons to the conduction band. Thus, doping this material with iron will make it tend to have a high resistivity, except in the electron-rich accumulation layer. It would in this case be desirable to grow a thin undoped $In_{0.53}Ga_{0.47}As$ layer (e.g., 0.1 micrometre thick, after correcting for iron diffusion effects) on top of the iron-doped layer in order to obtain the highest possible electron mobility and density in the accumulation layer. It is recognized however, that finding suitable dopants with large activation energies may not be practical for smaller band gap semi-conductive materials. Furthermore, the other embodiments discussed above could also be used in conjunction with this one advantageously to reduce the conductivity of the film adjacent to the high electron density region.

The emphasis of the above discussion has been on electron accumulation or inversion layers. Hole accumulation or inversion layers could also be used. However, electrons are usually preferred as current carriers in magnetoresistors since they have higher mobilities in the materials shown in Table I.

The inventors think that these types of magnetoresistors are especially attractive for automotive applications as part of linear or rotary position measurement systems. The sensitivity to magnetic field and high thermal stability of these sensors would be especially useful when used in combination with an optimized magnetic circuit which is described in European patent application number 0 357 200A based on USSN 229,396. It is believed that the selection of the hereinbefore-described type of magnetoresistor sensor is especially useful in the type of magnetic circuit described in this co-pending patent application. The inventors believe that their invention will enhance the magnetic sensitivity of magnetoresistors made from a wide variety of materials. Many of these materials may not produce sensors having high magnetic sensitivity to be ordinarily useful. However, their magnetic sensitivity may extend up to higher temperatures where high magnetic sensitivity materials are not useful. However, the inventors believe that this type of magnetic circuit is so effective in concentrating the magnetic field that the lesser sensitive magnetoresistors may still work well enough to be useful. In addition they would permit use at decidedly higher temperatures. In any event it is believed that use of the sensors of the present invention in such an application should provide many advantages. A separate European patent application number 0 357 199A, based upon USSN 289,641 is being concurrently filed on this latter use of the sensors of the present invention.

## Claims

1. A magnetoresistor-type sensor providing electrical output changes in response to changes in an applied magnetic field, said sensor comprising: a substrate and a thin film of monocrystalline semi-conductive material disposed on said substrate, said thin film having a face opposite from its interface with said substrate, said monocrystalline semi-conductive thin film including a substantially rectangular sensing area of a given conductivity type for sensing a magnetic field applied perpendicularly to said film, said given conductivity type sensing area having conductor strips disposed along opposed long edges thereof, whereby said conductor strips are in low resistance electrical communication with said sensing area; in which sensor said electrical output changes are identifiable even when the sensor is exposed to temperatures up to over 220°C; said substrate comprises a substantially electrically-insulating monocrystalline substrate having a thermal expansion characteristic close to that of said monocrystalline semi-conductive thin film; said substrate has a crystal lattice constant close to that of said monocrystalline semi-conductive thin film at said interface; and said monocrystalline semi-conductive thin film is of a thickness no greater than about 5 micrometres and is of a given average current carrier density and a given average current carrier mobility; an accumulation layer in said thin film extends across said sensing area adjacent said face of said film, where said current carriers can preferentially flow between said conductor strips along said opposed edges of said sensing area, which accumulation layer is induced without using externally-biased gate electrodes and is effective to provide an apparent increase in carrier mobility and concentration in said semi-conductive material, an apparent reduction in thickness of said film, and an actual improvement in the magnetic sensitivity of said film and in the temperature insensitivity of the magnetic sensitivity of said film.

2. A sensor according to claim 1, characterised in that the length of each short edge of rectangular sensing area is about 30% - 50% of the length of each long edge thereof, the given average current carrier density is not significantly greater than about $10^{16}$ electrons per cubic centimetre, and the given average current carrier mobility is greater than 10,000 square centimetres per volt per second.

3. A sensor according to claim 1 or 2, characterised in that said substrate includes a plurality of said thin film sensing areas, and said plurality of sensing areas are connected electrically in series with one another.

4. A sensor according to claim 1 or 2, characterised in that said monocrystalline semi-conductive thin film is of a semiconductor material having a band gap of at least 0.35 electron volts and has an elongated portion, the elongated portion comprises a plurality of successive sensing areas, each successive sensing area extends across the width of the elongated portion, the sensing areas are electrically connected in series with one another, and a conductive coating extends completely across said elongated portion between adjacent ones of said successive sensing areas, so that power consumption of said sensor is significantly reduced but sensor size is not significantly increased.

5. A sensor according to claim 1, characterised in that the sensor provides unamplified electrical output changes in response to changes in applied magnetic field over a temperature range of from below 0°C to over 300°C; said substrate is substantially electrically insulating and monocrystalline, and contains few crystal defects; said substantially rectangular sensing area has a dimension along its short edges that is about 30% - 50% that of its long edges; said film of monocrystalline semi-conductive material is essentially undoped, and has an average electron density not substantially greater than about $10^{16}$ electrons per cubic centimetre and an average electron mobility greater than 10,000 square centimetres per volt per second; the electron accumulation layer adjacent the outer surface of said semi-conductive film extends entirely across the sensing area between the conductor strips contacting its long edges, which accumulation layer has an electron density of at least an order of magnitude higher than said given average electron density and an electron mobility that is significantly greater than said given average electron mobility, and which is effective to provide a magnetic sensitivity and range of operating temperature as if the semi-conductive thin film were apparently much thinner and had a much higher electron density and electron mobility; and there are means adjacent the face of said thin film of monocrystalline semi-conductive material for artificially inducing said accumulation layer in said face of said monocrystalline semi-conductive thin film.

6. A sensor according to claim 5, <u>characterised in that</u> said monocrystalline thin film of semi-conductive material has an elongated portion, the elongated portion comprises a plurality of successive sensing areas, each successive sensing area extends across the width of the elongated portion, the sensing areas are electrically connected in series with one another, and a conductive coating extends completely across said elongated portion between adjacent ones of said successive sensing areas, so that power consumption of said sensor is significantly reduced but sensor size is not significantly increased.

7. A sensor according to claim 6, <u>characterised in that</u> the plurality of sensing areas is a plurality of over 10, and the conductive coating over the sensing area is a metal gate electrode disposed on a dielectric layer.

8. A sensor according to claim 5, <u>characterised in that</u> said monocrystalline film (22) of semi-conductive material is about 1 - 3 micrometres thick and is essentially undoped, and has a band gap of at least 0.35 electron volt, a moderate average electron density and moderate average electron mobility; and there is a coating means (60,62) on the exposed sensing area of said film face for inducing and maintaining said accumulation layer in said thin film.

9. A sensor according to claim 8, <u>characterised in that</u> said means for inducing said accumulation layer in said thin film is a coating on said surface, which coating includes a discrete portion of a metal layer over said sensing area.

10. A sensor according to claim 9, <u>characterised in that</u> said substrate includes a plurality of said thin film sensing areas, said sensing areas are electrically in series with one another, and said coating induces said accumulation layer in said film without application of a voltage from an electrical contact to said sensor in addition to respective electrical contacts made to said sensing area conductors.

11. A sensor according to claim 10, <u>characterised in that</u> said film has an elongated portion, each end of which has an electrical contact for electrically biasing said sensing areas in series with one another, said substrate includes a resistor network, and said resistor network is interconnected with said discrete portions of said metal layer and said electrical contacts to concurrently electrically bias said metal layer portions with respect to their respective sensing areas of said film when said sensing areas are biased, so as to concurrently induce or enhance said accumulation layer in said film.

12. A sensor according to claim 8, <u>characterised in that</u> said coating means for inducing said accumulation layer in said thin film includes an electrode layer, the electrode layer is disposed over said sensing area, and said electrode layer is electrically biased when an electrical potential is applied to one of said conductors contacting the long edges of said sensing area.

13. A sensor according to claim 8, <u>characterised in that</u> said monocrystalline film of semi-conductive material has an elongated portion, the elongated portion comprises a plurality of successive sensing areas, each successive sensing area extends across the width of the elongated portion, the sensing areas are electrically connected in series with one another, and a conductive coating extends completely across said elongated portion between adjacent ones of said successive sensing areas, so that power consumption of said sensor is significantly

14. A method of making a sensor according to claim 1, which method comprises the steps of: providing a substantially electrically insulating monocrystalline substrate; depositing a nominally undoped monocrystalline film of a substantially lattice-matching semi-conductive material onto said substrate to a thickness of less than 5 micrometres, using a metal organic chemical vapor deposition process; defining a rectangular magnetic field sensing area on said film; forming an elongated conductor along each long edge of said rectangular sensing area, whereby current carriers can be injected into said sensing area for detection of a magnetic field; and coating said sensing area with at least one layer for maintaining an accumulation layer induced in said film. reduced but sensor size is not significantly increased.

15. A method of making a sensor according to claim 14, in which the substantially lattice-matching semiconductive material is deposited onto said substrate to a thickness of less than 3 micrometres, said semconductive material has a band gap of at least about 0.35 electron volt and a given average carrier concentration and given average electron mobility; and said sensing area is coated with at least one layer for inducing or enhancing said accumulation layer in said sensing area of said film.

## Patentansprüche

1. Ein Sensor vom Magnetoresistor-Typ, der elektrische Ausgangsänderungen in Abhängigkeit von Änderungen in einem angelegten Magnetfeld liefert, wobei der Sensor umfaßt: ein Substrat und einen dünnen Film aus monokristallinem, halbleitenden Material, das auf dem Substrat angeordnet ist, wobei der dünne Film eine seiner Übergangsfläche zum Substrat gegenüberliegende Seite aufweist, der monokristalline, halbleitende dünne Film einen im wesentlichen rechtwinkligen Wahrnehmungsbereich eines gegebenen Leitfähigkeitstyps zum Wahrnehmen eines senkrecht zu dem Film angelegten Magnetfeldes umfaßt, der gegebene Leitfähigkeitstyp-Wahrnehmungsbereich Leiterstreifen aufweist, die entlang seiner gegenüberliegenden langen Kanten angeordnet sind, wodurch sich die Leiterstreifen in einer elektrischen Verbindung geringen Widerstands mit dem Wahrnehmungsbereich befinden; wobei in dem Sensor die elektrischen Ausgangsänderungen selbst dann identifizierbar sind, wenn der Sensor Temperaturen bis zu über 220°C ausgesetzt ist; das Substrat ein im wesentlichen elektrisch isolierendes, monokristallines Substrat mit einer thermischen Ausdehnungscharakteristik nahe derjenigen des monokristallinen, halbleitenden dünnen Films aufweist; das Substrat eine Kristallgitterkonstante nahe derjenigen des monokristallinen, halbleitenden dünnen Films an der Übergangsfläche aufweist; der monokristalline, halbleitende dünne Film eine Dicke aufweist, die nicht größer als etwa 5 Mikrometer ist, sowie eine gegebene durchschnittliche Stromträgerdichte und eine gegebene durchschnittliche Stromträgerbeweglichkeit aufweist; und eine Akkumulationsschicht in dem dünnen Film sich über den Wahrnehmungsbereich hinweg benachbart der Seite des Films erstreckt, wo die Stromträger vorzugsweise zwischen den Leiterstreifen entlang der gegenüberliegenden Kanten des Wahrnehmungsbereiches fließen können, wobei die Akkumulationsschicht ohne Verwendung extern vorgespannter Gate-Elektroden induziert wird und das Schaffen eines merklichen Anstiegs in der Trägerbeweglichkeit und der Konzentration im halbleitenden Material, einer merklichen Reduzierung der Dicke des Films und einer tatsächlichen Verbesserung der Magnetempfindlichkeit des Films und der Temperatur-Unempfindlichkeit der Magnetempfindlichkeit des Films bewirkt.

2. Ein Sensor nach Anspruch 1,
dadurch gekennzeichnet,
daß die Länge jeder kurzen Kante des rechtwinkligen Wahrnehmungsbereiches etwa 30 % - 50 % der Länge jeder seiner langen Kanten beträgt, die gegebene durchschnittliche Stromträgerdichte nicht signifikant größer als etwa $10^{16}$ Elektronen pro Kubikzentimeter ist, und die gegebene durchschnittliche Stromträgerbeweglichkeit größer als 10.000 Quadratzentimeter pro Volt pro Sekunde ist.

3. Ein Sensor nach Anspruch 1 oder 2,
dadurch gekennzeichnet,
daß das Substrat eine Vielzahl der Dünnfilmwahrnehmungsbereiche umfaßt und die Vielzahl von Wahrnehmungsbereichen elektrisch in Reihe geschaltet ist.

4. Ein Sensor nach Anspruch 1 oder 2,
dadurch gekennzeichnet,
daß der monokristalline, halbleitende dünne Film aus einem Halbleitermaterial mit einer Bandlücke von wenigstens 0,35 Elektronenvolt besteht und einen länglichen Teil aufweist, der längliche Teil eine Vielzahl sukzessiver Wahrnehmungsbereiche umfaßt, jeder sukzessive Wahrnehmungsbereich sich über die Breite des länglichen Teils erstreckt, die Wahrnehmungsbereiche elektrisch in Reihe geschaltet sind, und eine leitfähige Beschichtung sich vollständig über den länglichen Teil zwischen benachbarten Bereichen der sukzessiven Wahrnehmungsbereiche erstreckt, so daß der Leistungsverbrauch des Sensors signifikant reduziert, jedoch die Sensorgröße nicht signifikant vergrößert ist.

5. Ein Sensor nach Anspruch 1,
dadurch gekennzeichnet,
daß der Sensor unverstärkte elektrische Ausgangsänderungen in Abhängigkeit von Änderungen im angelegten Magnetfeld über einen Temperaturbereich von unter 0°C bis über 300°C liefert; das Substrat im wesentlichen elektrisch isolierend und monokristallin ist und wenige Kristalldefekte enthält; der im wesentlichen rechtwinklige Wahrnehmungsbereich eine Abmessung entlang seiner kurzen Kanten aufweist, die etwa 30 % - 50 % von derjenigen seiner langen Kanten beträgt; der Film aus monokristallinem, halbleitenden Material im wesentlichen undotiert ist und eine durchschnittliche Elektronendichte von nicht wesentlich mehr als etwa $10^{16}$ Elektronen pro Kubikzentimeter und eine durchschnittliche Elektronenbeweglichkeit von mehr als 10.000 Quadratzentimeter pro Volt pro Sekunde aufweist; die Elektronenakkumulationsschicht benachbart der äußeren Oberfläche des halbleitenden Films sich ganz über den Wahrnehmungsbereich zwischen den seine langen Kanten kontaktierenden Leiterstreifen erstreckt, wobei die Akkumulationsschicht eine Elektronendichte, die wenigstens eine Größenordnung höher als die gegebene durchschnittliche Elektronendichte liegt, und eine Elektronenbeweglichkeit aufweist, die signifikant größer als die gegebene durchschnittliche Elektronenbeweglichkeit ist, und die das Schaffen einer magnetischen Empfindlichkeit und eines Betriebstemperaturbereiches bewirkt, als wäre der halbleitende dünne Film scheinbar viel dünner und als hätte er eine viel höhere Elektronendichte und Elektronenbeweglichkeit; und Mittel benachbart der Seite des dünnen Filmes aus monokristallinem, halbleitenden Material vorgesehen sind, um künstliche die Akkumulationsschicht in der Seite des monokristallinen, halbleitenden dünnen Films zu induzieren.

6. Ein Sensor nach Anspruch 5,
dadurch gekennzeichnet,
daß der monokristalline dünne Film aus halbleitendem Material einen länglichen Teil aufweist, der längliche Teil eine Vielzahl von sukzessiven Wahrnehmungsbereichen umfaßt, jeder sukzessive Wahrnehmungsbereich sich über die Breite des länglichen Teils erstreckt, die Wahrnehmungsbereiche elektrisch in Reihe geschaltet sind, und eine leitfähige Beschichtung sich vollständig über den länglichen Teil zwischen benachbarten Bereichen der sukzessiven Wahrnehmungsbereiche erstreckt, so daß der Leistungsverbrauch des Sensors signifikant reduziert, jedoch die Sensorgröße nicht signifikant vergrößert ist.

7. Ein Sensor nach Anspruch 6,
dadurch gekennzeichnet,
daß die Vielzahl von Wahrnehmungsbereichen eine Vielzahl von über 10 ist und die leitfähige Beschichtung über dem Wahrnehmungsbereich eine Metall-Gate-Elektrode ist, die auf einer dielektrischen Schicht angeordnet ist.

8. Ein Sensor nach Anspruch 5,
dadurch gekennzeichnet,
daß der monokristalline Film (22) aus halbleitendem Material etwa 1 - 3 Mikrometer dick und im wesentlichen undotiert ist sowie eine Bandlücke von wenigstens 0,35 Elektronenvolt, eine mittlere durchschnittliche Elektronendichte und eine mittlere durchschnittliche Elektronenbeweglichkeit aufweist; und ein Beschichtungsmittel (60, 62) auf dem freiliegenden Wahrnehmungsbereich der Filmseite vorgesehen ist, um die Akkumulationsschicht in dem dünnen Film zu induzieren und aufrechtzuerhalten.

9. Ein Sensor nach Anspruch 8,
dadurch gekennzeichnet,
daß das Mittel zum Induzieren der Akkumulationsschicht in dem dünnen Film eine Beschichtung auf der Oberfläche ist, wobei die Beschichtung einen diskreten Teil einer Metallschicht über dem Wahrnehmungsbereich umfaßt.

10. Ein Sensor nach Anspruch 9,
dadurch gekennzeichnet,
daß das Substrat eine Vielzahl der dünnen Filmwahrnehmungsbereiche umfaßt, die Wahrnehmungsbereiche elektrisch in Reihe geschaltet sind, und die Beschichtung die Akkumulationsschicht in dem Film ohne Anlegen einer Spannung von einem elektrischen Kontakt mit dem Sensor zusätzlich zu jeweiligen,

EP 0 375 107 B1

mit den Wahrnehmungsbereichsleitern ausgeführten elektrischen Kontakten induziert.

**11.** Ein Sensor nach Anspruch 10,
dadurch gekennzeichnet,
daß der Film einen länglichen Teil aufweist, von dem jedes Ende einen elektrischen Kontakt aufweist, um die Wahrnehmungsbereiche elektrisch in Reihe vorzuspannen, das Substrat ein Widerstandsnetzwerk umfaßt, und das Widerstandsnetzwerk mit den diskreten Teilen der Metallschicht und den elektrischen Kontakten verbunden ist, um gleichzeitig die Metallschichtteile bezüglich ihrer jeweiligen Wahrnehmungsbereiche des Films vorzuspannen, wenn die Wahrnehmungsbereiche vorgespannt sind, und somit gleichzeitig die Akkumulationsschicht in dem Film zu induzieren oder zu steigern.

**12.** Ein Sensor nach Anspruch 8,
dadurch gekennzeichnet,
daß das Beschichtungsmittel zum Induzieren der Akkumulationsschicht in dem dünnen Film eine Elektrodenschicht umfaßt, die Elektrodenschicht über dem Wahrnehmungsbereich angeordnet ist, und die Elektrodenschicht elektrisch vorgespannt ist, wenn ein elektrisches Potential an einen der die langen Kanten des Wahrnehmungsbereiches kontaktierenden Leiter angelegt ist.

**13.** Ein Sensor nach Anspruch 8,
dadurch gekennzeichnet,
daß der monokristalline Film aus halbleitendem Material einen länglichen Teil aufweist, der längliche Teil eine Vielzahl von sukzessiven Wahrnehmungsbereichen umfaßt, jeder sukzessive Wahrnehmungsbereich sich über die Breite des länglichen Teils erstreckt, die Wahrnehmungsbereiche elektrisch in Reihe geschaltet sind, und eine leitfähige Beschichtung sich vollständig über den länglichen Teil zwischen benachbarten Bereichen der sukzessiven Wahrnehmungsbereiche erstreckt, so daß der Leistungsverbrauch des Sensors signifikant reduziert, jedoch die Sensorgröße nicht signifikant vergrößert ist.

**14.** Ein Verfahren zur Herstellung eines Sensors nach Anspruch 1, wobei das Verfahren die Schritte umfaßt, daß: ein im wesentlichen elektrisch isolierendes, monokristallines Substrat geschaffen wird; ein nominell undotierter, monokristalliner Film aus einem im wesentlichen gitterübereinstimmenden, halbleitenden Material auf dem Substrat bis zu einer Dicke von weniger als 5 Mikrometer unter Verwendung eines organisch-chemischen Metalldampfablagerungsprozesses abgelagert wird; ein rechtwinkliger Magnetfeldwahrnehmungsbereich auf dem Film definiert wird; ein länglicher Leiter entlang jeder langen Kante des rechtwinkligen Wahrnehmungsbereiches gebildet wird, wodurch Stromträger in den Wahrnehmungsbereich zum Nachweis eines Magnetfeldes injiziert werden können; und der Wahrnehmungsbereich mit wenigstens einer Schicht überzogen wird, um eine in dem Film induzierte Akkumulationsschicht aufrechtzuerhalten.

**15.** Ein Verfahren zur Herstellung eines Sensors nach Anspruch 14,
bei dem das im wesentlichen gitterübereinstimmende, halbleitende Material auf dem Substrat bis zu einer Dicke von weniger als 3 Mikrometer abgelagert wird, das halbleitende Material eine Bandlücke von wenigstens etwa 0,35 Elektronenvolt und eine gegebene durchschnittliche Trägerkonzentration und eine gegebene durchschnittliche Elektronenbeweglichkeit aufweist; und der Wahrnehmungsbereich mit wenigstens einer Schicht überzogen ist, um die Akkumulationsschicht in dem Wahrnehmungsbereich des Films zu induzieren oder zu steigern.

## Revendications

**1.** Capteur du type à magnétorésistance fournissant des variations de signal électrique de sortie en réponse à des variations d'un champ magnétique appliqué, ledit capteur comprenant :
un substrat et une couche mince d'un matériau semi-conducteur monocristallin disposée sur ledit substrat, ladite couche mince ayant une face en regard de son interface avec ledit substrat ; ladite couche de matériau semi-conducteur monocristallin comprenant une zone de détection de forme sensiblement rectangulaire d'un type donné de conductivité pour détecter un champ magnétique appliqué perpendiculairement à ladite couche, ladite zone de détection d'un type donné de conductivité ayant des bandes conductrices disposées le long de ses bords longs opposés, de sorte que lesdites bandes conductrices sont en communication de résistance électrique faible avec ladite zone de détection ; capteur dans lequel lesdites variations de signal électrique sont identifiables même quand le capteur est exposé à des températures pouvant dépasser 220° C ; ledit substrat comprend un substrat monocristallin pratiquement isolant électriquement, ayant une caractéristique de dilatation thermique proche de celle de ladite couche mince semi-conductrice monocristalline ; ledit substrat a une constante de réseau cristallin proche de celle de ladite couche mince semi-conductrice monocristalline à ladite interface ; et ladite couche mince semi-conductrice monocristalline a une épaisseur non supérieure à environ 5 micromètres et a une densité moyenne donnée de porteurs de courant et une mobilité moyenne donnée de porteurs de courant ; une couche d'accumulation dans ladite couche mince s'étend à travers ladite zone de détection adjacente à ladite face de ladite couche, dans laquelle lesdits porteurs de courant peuvent de préférence circuler entre lesdites bandes conductrices le long desdits bords opposés de ladite zone de détection, laquelle couche d'accumulation est induite sans utilisation d'électrodes de grille polarisées de manière externe et est adaptée pour fournir un accroissement apparent de la mobilité et de la concentration des porteurs dans ledit matériau semi-conducteur, une réduction apparente de l'épaisseur dudit film, et une amélioration effective de la sensibilité magnétique dudit film et de l'insensibilité à la température de la sensibilité magnétique dudit film.

2. Capteur selon la revendication 1, caractérisé en ce que la longueur de chaque bord court de la zone rectangulaire de détection est d'environ 30 à 50 % de la longueur de chacun de ses bords longs, la densité moyenne donnée de porteurs de courant n'est pas sensiblement supérieure à environ $10^{16}$ électrons par centimètre cube, et la mobilité moyenne donnée de porteurs de courant est supérieure à 10 000 centimètres carrés par volt par seconde.

3. Capteur selon la revendication 1 ou 2, caractérisé en ce que ledit substrat comporte une pluralité desdites zones de détection de couche mince, et ladite pluralité de zones de détection sont branchées électriquement en série les unes avec les autres.

4. Capteur selon la revendication 1 ou 2, caractérisé en ce que ladite couche mince semi-conductrice monocristalline est en un matériau semi-conducteur ayant une bande interdite d'au moins 0,35 électron-volt et a une portion allongée, la portion allongée comprend une pluralité de zones successives de détection, chaque zone successive de détection s'étend sur la largeur de la portion allongée, les zones de détection sont branchées électriquement en série les unes avec les autres, et un revêtement conducteur s'étend complètement sur ladite portion allongée entre des zones adjacentes desdites zones successives de détection, de sorte que la consommation d'énergie dudit capteur est fortement réduite mais la dimension du capteur n'est pas sensiblement augmentée.

5. Capteur selon la revendication 1, caractérisé en ce que le capteur fournit des variations non amplifiées de tension électrique de sortie en réponse à des variations de champ magnétique appliqué sur une gamme de température inférieure à 0° C jusqu'à plus de 300° C ; ledit substrat est pratiquement électriquement isolant et monocristallin, et contient peu de défauts cristallins ; ladite zone de détection sensiblement rectangulaire a une dimension le long de ses bords courts qui est d'environ 30 % à 50 % celle de ses bords longs ; ladite couche de matériau semi-conducteur monocristallin est pratiquement non dopée, et a une densité moyenne d'électrons non sensiblement supérieure à $10^{16}$ électrons par centimètre cube et une mobilité moyenne de porteurs de courant qui est supérieure à 10 000 centimètres carrés par volt par seconde ; la couche d'accumulation d'électrons adjacente à la surface extérieure de ladite couche semi-conductrice s'étend entièrement sur la zone de détection entre les bandes conductrices entrant en contact avec ses bords longs, et cette couche d'accumulation a une densité d'électrons supérieure d'au moins un ordre de grandeur à ladite densité moyenne d'électrons et une mobilité d'électrons qui est sensiblement supérieure à ladite mobilité moyenne d'électrons, et cette couche est efficace pour fournir une sensibilité magnétique et une gamme de températures de fonctionnement comme si la couche mince semi-conductrice était apparemment beaucoup plus mince et avait une densité d'électrons et une mobilité d'électrons plus élevées ; et en ce qu'il existe des moyens adjacents à la face de ladite couche mince de matériau semi-conducteur monocristallin pour créer artificiellement ladite couche d'accumulation dans ladite face de ladite couche mince semi-conductrice monocristalline.

6. Capteur selon la revendication 5, caractérisé en ce que ladite couche mince monocristalline de matériau semi-conducteur a une portion allongée, la portion allongée comprend une pluralité de zones successives de détection, chaque zone successive de détection s'étend sur la largeur de la portion allongée, les zones de détection sont branchées électriquement en série les unes avec les autres, et un revêtement conducteur s'étend complètement sur ladite portion allongée entre celles adjacentes desdites zones successives de détection, de sorte que la consommation d'énergie dudit capteur est sensiblement réduite mais que la dimension du capteur n'est pas sensiblement augmentée.

**7.** Capteur selon la revendication 6, caractérisé en ce que la pluralité de zones de détection est une pluralité de plus de dix, et que le revêtement conducteur sur la zone de détection est une électrode métallique de grille disposée sur une couche diélectrique.

**8.** Capteur selon la revendication 5, caractérisé en ce que ladite couche monocristalline (22) de matériau semi-conducteur a environ 1 à 3 micromètres d'épaisseur et est essentiellement non dopée, et a une bande interdite d'au moins 0,35 électron-volt, une densité moyenne modérée d'électrons et une mobilité moyenne modérée d'électrons ; et qu'il existe des moyens de revêtement (60, 62) sur la zone exposée de détection de ladite face de couche pour créer et maintenir ladite couche d'accumulation dans ladite couche mince.

**9.** Capteur selon la revendication 8, caractérisé en ce que lesdits moyens pour créer ladite couche d'accumulation dans ladite couche mince sont un revêtement sur ladite surface, et que ce revêtement comprend une portion discrète d'une couche métallique sur ladite zone de détection.

**10.** Capteur selon la revendication 9, caractérisé en ce que ledit substrat comprend une pluralité desdites zones de détection de couche mince, lesdites zones de détection sont branchées électriquement en série les unes avec les autres, et ledit revêtement crée ladite couche d'accumulation dans ladite couche sans application audit capteur d'une tension depuis un contact électrique en plus de contacts électriques correspondants établis avec lesdits conducteurs de zone de détection.

**11.** Capteur selon la revendication 10, caractérisé en ce que ladite couche a une portion allongée dont chaque extrémité a un contact électrique pour polariser électriquement lesdites zones de détection en série les unes avec les autres, ledit substrat comprend un réseau de résistances, et ledit réseau de résistances est interconnecté avec lesdites portions discrètes de ladite couche métallique et desdits contacts électriques pour polariser électriquement à la fois lesdites portions de couche métallique par rapport à leurs zones correspondantes de détection de ladite couche quand des zones de détection sont polarisées, afin de créer ou d'augmenter simultanément ladite couche d'accumulation dans ladite couche mince.

**12.** Capteur selon la revendication 8, caractérisé en ce que lesdits moyens de revêtement pour créer ladite couche d'accumulation dans ladite couche mince comprennent une couche servant d'électrode, la couche servant d'électrode est disposée sur ladite zone de détection, et ladite couche servant d'électrode est polarisée électriquement quand un potentiel électrique est appliqué à un desdits conducteurs en contact avec les bords longs de ladite zone de détection.

**13.** Capteur selon la revendication 8, caractérisé en ce que ladite couche monocristalline de matériau semi-conducteur a une portion allongée, la portion allongée comprend une pluralité de zones successives de détection, chaque zone successive de détection s'étend sur la largeur de la portion allongée, les zones de détection sont branchées électriquement en série les unes avec les autres, et un revêtement conducteur s'étend complètement sur ladite portion allongée entre celle adjacentes desdites zones successives de détection, de sorte que la consommation d'énergie dudit capteur est sensiblement réduite mais que la dimension du capteur n'est pas sensiblement augmentée.

**14.** Procédé pour fabriquer un capteur selon la revendication 1, ce procédé comprenant les étapes suivantes :
fournir un substrat monocristallin électriquement isolant ;
déposer une couche mince monocristalline nominalement non dopée d'un matériau semi-conducteur ayant un réseau concordant sensiblement sur ledit substrat jusqu'à une épaisseur inférieure à 5 micromètres, en utilisant un processus de dépôt chimique de métal organique en phase vapeur ;
définir une zone rectangulaire de détection de champ magnétique sur ladite couche mince ;
former un conducteur allongé le long de chaque bord long de ladite zone rectangulaire de détection, de sorte que des porteurs de courant puissent être injectés dans ladite zone de détection pour détecter un champ magnétique ; et
revêtir ladite zone de détection avec au moins une couche pour maintenir une couche d'accumulation créée dans ladite couche mince.

15. Procédé pour fabriquer un capteur selon la revendication 14, dans lequel le matériau semi-conducteur à réseau sensiblement concordant est déposé sur ledit substrat jusqu'à une épaisseur inférieure à 3 micromètres, ledit matériau semi-conducteur a une bande interdite d'au moins 0,35 électron-volt environ et une concentration moyenne donnée de porteurs et une mobilité moyenne donnée de porteurs ; et ladite zone de détection est revêtue avec au moins une couche pour créer et augmenter ladite couche d'accumulation dans ladite zone de détection de ladite couche mince.

# Fig.1a.

B = 0

# Fig.1b.

B
⊙

# Fig.2.

Semiconductor
Epitaxial Layer

Contact

Metal

Electrons

Contact

High Mobility
Semiconductor
Layer

Insulating
Substrate

Magnetic Field

Fig. 3.

## Fig.4.

Magnetoresitor InAs/Inp
SENSITIVITY AT 0.4 TELSA

## Fig.5.

Magnetoresistor InAs/InP

## Fig.6.

## Fig.7a.

## Fig.7b.

Fig.8.

## Fig. 9.

Electron
Energy

Schottky
Barrier

Confined Electrons

Conduction
Band Edge

Substrate

Metal

Active
Region

Valence
Band Edge

DEPTH

## Fig.10.

Electron
Energy

Accumulation

Layer

Conduction
Band Edge

Substrate

Metal

Active
Region

Valence
Band Edge

Dielectric

DEPTH